# EUROPEAN PATENT APPLICATION

(11) **EP 1 041 634 A1**
(43) Date of publication of application: **04.10.2000**
(21) Application number: 99106410.6
(22) Date of filing: 27.03.1999
(51) Int. Cl.: H01L 27/02

(54) **Power MOSFET having voltage-clamped gate**

(71) Applicant: SILICONIX INCORPORATED, Santa Clara, CA 95056-0951 (US)
(72) Inventor: Williams, Richard K., Cupertino, California 95014 (US)
(74) Representative: Kolb, Georg

(57) **Abstract**

A MOSFET contains a voltage clamp including one or more diodes which connects its gate and source. The voltage clamp is designed to break down at a predetermined voltage and thereby protects the gate oxide layer from damage as a result of an excessive source-to-gate voltage. One embodiment includes a second voltage clamp connected between the gate and source terminals of the MOSFET and a resistor connected in series with the first voltage clamp between the gate and source terminals. The second voltage clamp breaks down at a higher voltage than the first voltage clamp and provides a second level of protection, since the voltage across the series combination of the first voltage clamp and resistor cannot exceed the breakdown voltage of the second voltage clamp. The MOSFET and voltage clamps are preferably integrated in the same die, with the voltage clamps consisting of diodes formed of N and P regions in a polysilicon layer. The breakdown voltages of the clamps can be adjusted by varying the arrangement of the diodes and by varying the breakdown voltage of the individual diodes.

## Description

### FIELD OF THE INVENTION

This invention relates to metal-oxide-silicon field-effect transistors (MOSFETs) and in particular to power MOSFETs, i.e., MOSFETs that are used as switches to control to the flow of power to a device such as a laptop computer.

### BACKGROUND OF THE INVENTION

A key objective in designing power MOSFETs is to reduce the on-resistance, i.e., the resistance of the MOSFET when it is turned on, to as low a value as possible. One way to achieve this objective is to reduce the channel resistance by increasing the cell density of the device. This increases the total cell perimeter and thereby provides a greater total gate width through which the current flows. Another way is to improve the transconductance of the active transistor portion of each cell by creating greater electrostatic coupling between the gate and the silicon which makes up the channel region of the device. This can be done be decreasing the thickness of the gate oxide layer (the layer, typically silicon dioxide, that separates the gate from the channel), which provides a lower threshold voltage and improved electrostatic coupling between the gate and the channel.

The gate oxide cannot be thinned without limit, however, because making the gate oxide thinner reduces the maximum gate voltage that can be applied to the device without rupturing the gate oxide and permanently destroying the MOSFET. It is difficult to design gate drive circuitry whose output is regulated within strict limits, and furthermore many circuits are subject to certain fault conditions (e.g., voltage spikes arising from transient conditions) that occasionally subject the gate to much higher than normal operating voltages. These conditions require the designer to thicken the gate oxide layer. In essence, the normal performance of the device is significantly compromised to protect against rare occurrences.

A classic example of this problem is found in case of lithium ion batteries, where the industry has moved from power MOSFETs with 8-volt rated gates to MOSFETs with 12-volt rated gates because of a concern that the MOSFET might be subjected to a gate voltage pulse in the range of 12 volts or more when a battery charger is connected to the battery. As a result, the thickness of the gate oxide has been increased and the on-resistance of each MOSFET cell has been increased. Ultimately, this requires that more cells be used to obtain an equivalent on-resistance, and die sizes and costs must increase.

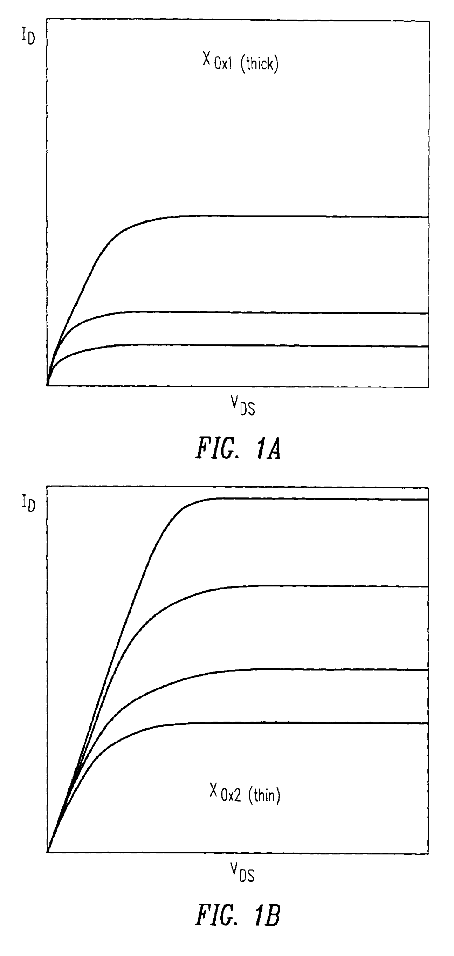

Figs. 1-6 are graphs which illustrate the problem in greater detail by showing some of the relevant characteristics of a MOSFET.

Figs. 1A and 1B show the current-voltage characteristics of MOSFETS which are otherwise identical but have gate oxide thicknesses X_{OX1} and X_{OX3}, where X_{OX1} > X_{OX3}. The vertical axis is the drain current I_{D}, the horizontal axis is the drain-to-source voltage V_{DS}, and each curve represents a different level of gate drive V_{GS}. It is apparent that the current is reduced in the device having the thicker gate oxide (Fig. 1A) because of its lower transconductance. Also, the slope of the curves in the linear region of the device is lower in the thin oxide device (Fig. 1B), indicating a lower resistance in this region.

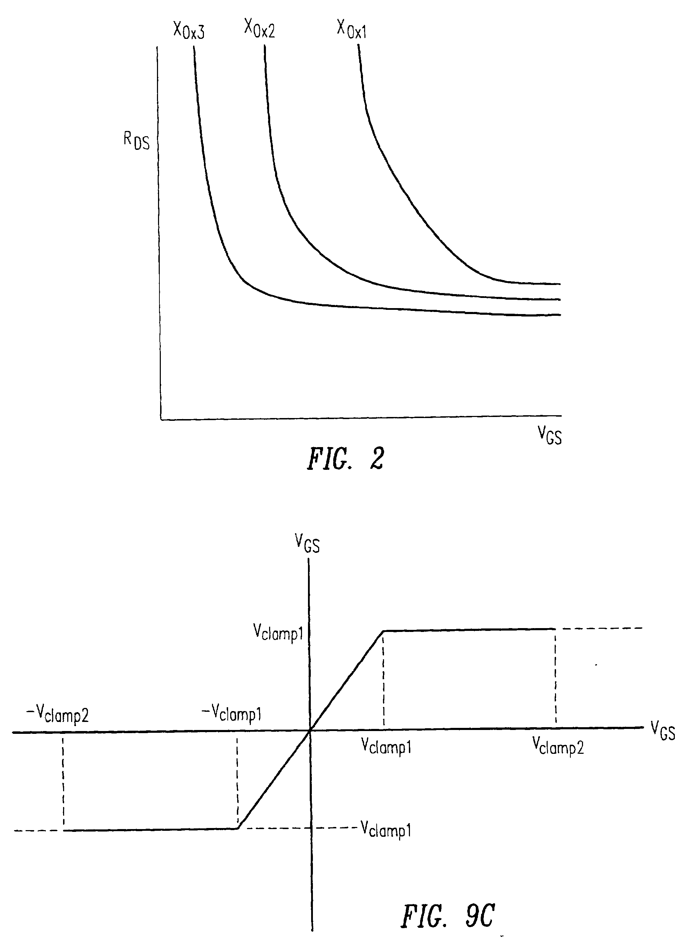

Fig. 2 shows the on-resistance R_{DS} of three MOSFETs having gate oxide thicknesses X_{OX1}, X_{OX2} and X_{OX3}, where X_{OX1} > X_{OX2} > X_{OX3}. On-resistance decreases with gate oxide thickness at all values of V_{GS}, and the curve for the device with the thinnest gate oxide (X_{OX3}) also has the sharpest corner indicating that it turns on more abruptly. Once the channel turns on, the total resistance of the device is almost immediately determined by other resistances such as the drain resistance. Moreover, this device can operate at gate voltages where the other two devices are completely turned off.

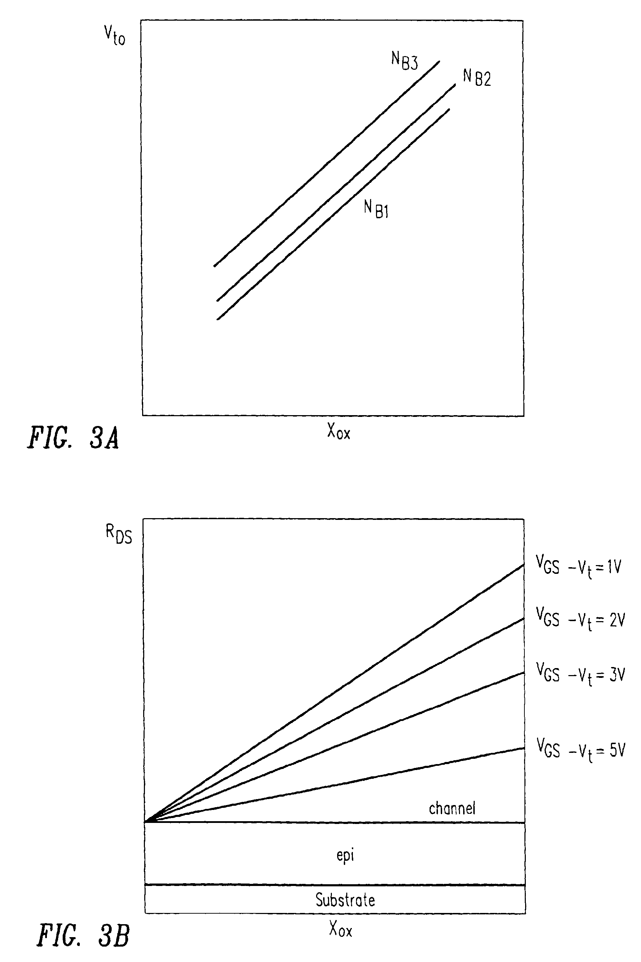

The threshold voltage of a MOSFET (the voltage at which it turns on) can be adjusted by varying the doping concentration of its body region. Fig. 3A shows the threshold voltage Vₜₒ of a MOSFET as a function of gate oxide thickness at three levels of body doping N_{B1}, N_{B2} and N_{B3}, where N_{B1} < N_{B2} < N_{B3}. As indicated, the threshold voltage falls as either the body doping becomes lighter or as the gate oxide becomes thinner. Fig. 3B shows the values of the components of on-resistance as a function of gate oxide thickness. The resistance of both the substrate and an epitaxial layer remain constant, but the resistance of the channel increases with increasing gate oxide thickness. The four curves in Fig. 3B are for different levels of gate "overdrive" (i.e., the gate voltage V_{GS} in excess of the threshold voltage Vₜ). As expected, the on-resistance decreases with increasing gate overdrive as a result of increased inversion in the channel region. The resistance in the channel is lowest when the gate overdrive is 5 V and is highest when the gate overdrive is 1 V. If the device has a lower breakdown voltage, the epitaxial (epi) resistance will be reduced and all of the curves will be shifted downward. By portraying the value of the gate overdrive, Fig. 3B separates out the effect of the gate oxide thickness on the threshold voltage, which is shown in Fig. 3A. The total on-resistance shown in Fig. 2 is the result of both of these factors. In other words, the reduced on-resistance at thinner gate oxides is the result both of reduced threshold voltage and increased transconductance.

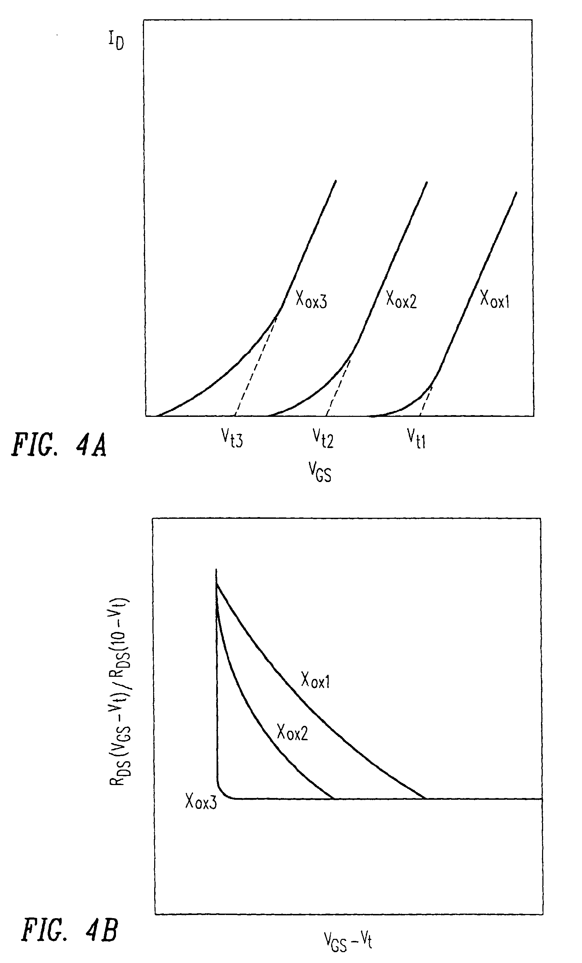

Fig. 4A shows the drain current I_{D} as a function of gate-to-source voltage V_{GS} for three gate oxide thicknesses (where X_{OX1} > X_{OX2} > X_{OX3}), as well as the threshold voltages Vₜ₁, Vₜ₂ and Vₜ₃, which are determined by extrapolating the linear portions of the curves to the horizontal axis (I_{D} = 0). As indicated, the threshold voltage is lowest when the gate oxide is thinnest. Fig. 4B shows the on-resistance as a function of the gate overdrive for gate oxide thicknesses of X_{OX1}, X_{OX2} and X_{OX3}, the on-resistance being normalized to the on-resistance at a 10 V gate overdrive. 10 V of gate overdrive is large compared to the variation in threshold voltage, so Fig. 4A essentially shows the percentage change in R_{DS}. The gate oxide having a thickness X_{OX3} has a clearly defined "L" shape, which means that the channel turns on very hard and the resistance becomes very constant when the device is turned on because the resistance is then unassociated with the channel but with other components that do not vary with gate oxide thickness. Clearly, thinning the gate oxide provides a sharper, more desirable turn-on characteristic as a result of both the threshold (Fig. 4A) and transconductance (Fig. 4B) effects. Figs. 4A and 4B thus show in a more direct manner the data illustrated in Figs. 3A and 3B, respectively.

As mentioned above, for a given gate oxide thickness there is a maximum gate-to-source voltage that the device can withstand without damage to the gate oxide. Fig. 5A shows this maximum gate-to-source voltage V_{GS}(max) as a function of gate oxide thickness (X_{OX}). For gate oxides more than about 200 Å thick the maximum V_{GS} is equal to about 8 MV per cm of gate oxide thickness. Below an oxide thickness of 200 Å, the maximum V_{GS} approaches an asymptote at about 10-12 MV per cm. The reason is that at a thickness above 200 Å conduction across the gate oxide depends on the carriers having sufficient kinetic energy to overcome the energy barrier between the silicon and the oxide, while with thinner gate oxides the mechanism of conduction is quantum mechanical tunneling through the gate oxide, which looks somewhat like a leakage current. This actually helps to prevent oxide rupture at electric fields as low as 8 MV/cm. Nonetheless, 8 MV/cm with a safety factor of 50% (i.e., 4 MV/cm) or, for example, 16 V on a 400 Å thick gate oxide or 12 V on a 300 Å thick gate oxide, has been widely accepted in the industry. While slightly higher gate-to-source voltages may be tolerable for very thin gate oxides (for example, while the 4 MV/cm standard would allow 7 V for a 175 Å thick gate oxide, 8 V might be tolerated), the fact remains there are definite limitations in one's ability to obtain improved on-resistance by thinning the gate oxide.

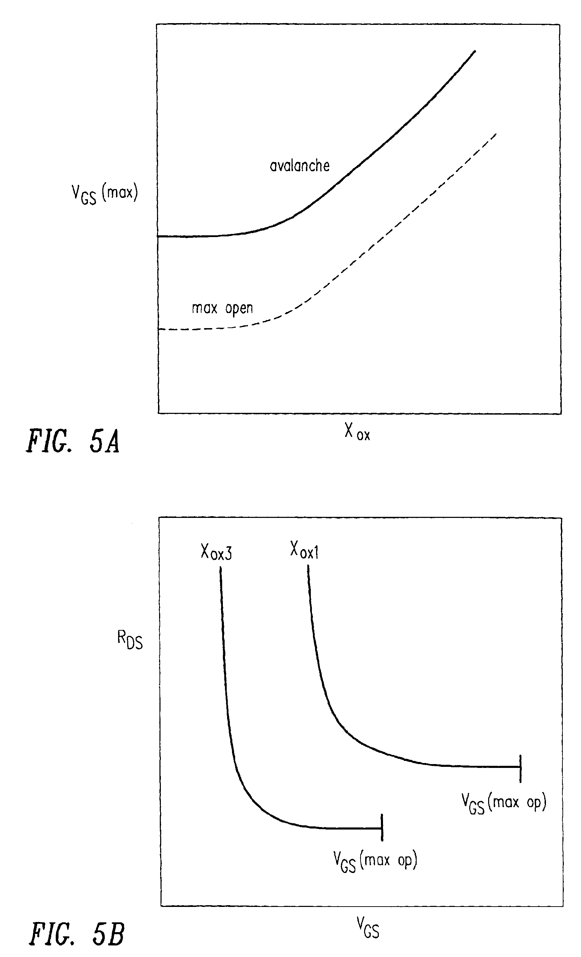

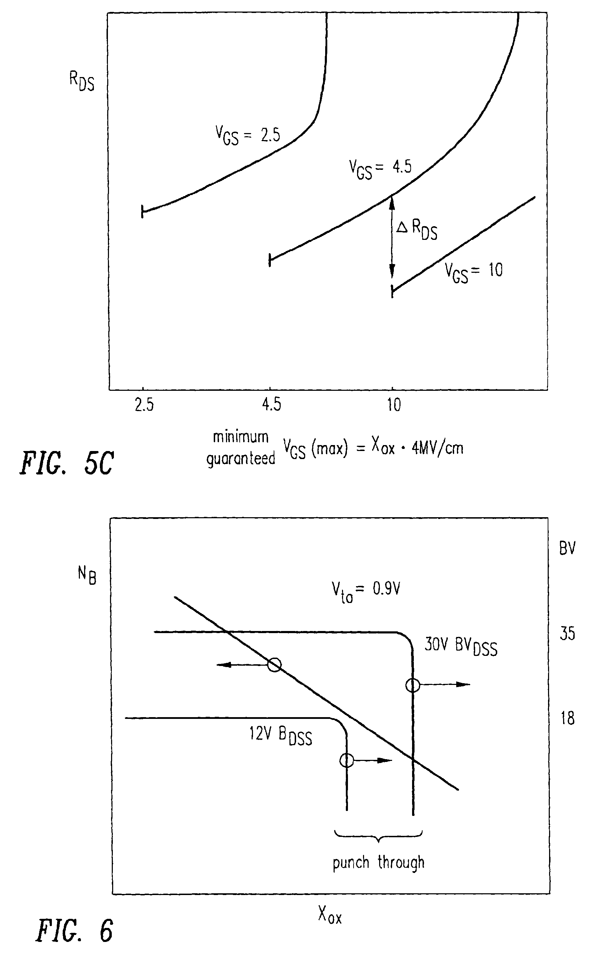

This limitation is illustrated in Fig. 5B, which is similar to Fig. 3 but shows that for each level of gate oxide thickness there is an upper limit to V_{GS}. As indicated, V_{GS}(max) is less for the thinner gate oxide (X_{OX3}) than it is for the thicker gate oxide (X_{OX1}). This is shown another way in Fig. 5C, which shows R_{DS} as a function of the minimum guaranteed value of V_{GS}(max) of a gate oxide at three values of V_{GS}. In other words, the horizontal axis is equivalent to gate oxide thicknesses. A minimum guaranteed V_{GS}(max) of 10 V is the equivalent of a 250 Å thick gate oxide, since any thinner gate oxide would not be able to support 10 V under the standard of 4 MV/cm. Each curve begins at the equivalent V_{GS} on the horizontal axis and rises quite linearly at first and then more steeply as the threshold effect comes into play. ΔR_{DS} represents the on-resistance penalty that is suffered by operating a MOSFET having a gate oxide which is the minimum thickness required to withstand a V_{GS} of 10 V at an actual V_{GS} of 4.5 V. This is the penalty that would be incurred if a device expected to operate at 4.5 V is designed to survive a fault condition resulting in a V_{GS} of 10 V. Notice that for low gate biases, e.g., 2.5 V, it becomes difficult to maintain a "low" on-resistance as the gate oxide thickness of the MOSFET increases. For example, for MOSFETs with a maximum V_{GS} of 12 V, the on-resistance is unacceptably high at a V_{GS} of 2.5 V.

The penalty shown in Fig. 5C arises because a thicker gate oxide yields both a loss of transconductance and higher threshold voltage. The higher threshold voltage can be counterbalanced by using a lighter body doping or a threshold adjust doping. The substantially linear curve in Fig. 6 shows the combinations of body doping level N_{B} and gate oxide thickness X_{OX} required to obtain a MOSFET having a threshold voltage Vₜₒ of 0.9 V. As one would expect, the required body doping level decreases as the gate oxide becomes thicker. The righthand vertical axis shows the drain-to-source voltage on two devices each having a Vₜₒ of 0.9 V. One of the devices has a rated breakdown voltage BV_{DSS} of 30 V; the other has a BV_{DSS} of 12 V. Since MOSFETs typically are designed to have an actual breakdown voltage somewhat in excess of their rated BV_{DSS}, the 30 V device is shown as having a V_{DS} of 35 V and the 12 V device is shown as having a V_{DS} of 18 V. For each device V_{DS} remains constant until the body doping gets so light that breakdown occurs. This breakdown occurs by the mechanism of punchthrough; the depletion region of the drain is punching or through the body to the source, and when this has happened the device conducts instantly by a barrier lowering mechanism, not from an avalanche. This type of breakdown is also known as drain-induced barrier lowering. Some persons skilled in the art refer to punchthrough mechanism as "reachthrough", owing to the behavior of the depletion region extending across the base. This term is not to be confused with the avalanche breakdown of a PIN (P+, intrinsic, N+) diode, where the depletion region "reaches through" the intrinsic region when the diode breaks down.

Punchthrough breakdown occurs in the 12 V device at a thinner gate oxide than in the 30 V device. This happens because the drain must be more heavily doped in the 12 V device, and this means that the depletion region will reach into the channel more quickly, and at a lower level of body doping, than in the 30 V device. Punchthrough therefore limits the maximum oxide thickness which can be used to produce a low threshold device. For example, it is difficult to make a MOSFET with a 0.9 V threshold voltage and a 20 or 30 V rated gate because the device would have to have such a light channel doping that its drain breakdown (e.g, 1 to 2 V) would be very low, even though its epitaxial layer was capable of a high avalanche voltage (e.g., 35 V).

### SUMMARY OF THE INVENTION

The problem described above is overcome by connecting a voltage clamp between the source and gate of a MOSFET. Preferably, one or more diodes are connected between the source and gate of the MOSFET. In normal operating conditions, the diodes are nonconductive and represent an open circuit. When the gate-to-source voltage exceeds a predetermined level, however, the diodes break down (or allow current to flow in the forward direction) and thereby clamp the voltage at the gate to a desired maximum level.

Numerous embodiments in accordance with this invention are possible. For example, a pair of diodes may be connected anode-to-anode in series between the gate and source to protect the gate oxide against both positive and negative voltage spikes. A resistance may be connected between the gate of the MOSFET cells and the gate terminal or pad of the power MOSFET to limit the current flow through the diodes in the event of a breakdown condition. Additional diodes (e.g., two pairs connected anode-to-anode) can be connected as a second voltage clamp between the gate and source pads to protect the initial diode pair.

The diodes are preferably integrated with the MOSFET, but they may be discrete devices, preferably within a single package to limit stray inductance. The diodes may be fabricated in polysilicon above the silicon or in the silicon itself.

### BRIEF DESCRIPTION OF THE DRAWINGS

The principles of this invention will be understood with reference to the following drawings, in which like components are identified by the same reference numbers.

Figs. 1A and 1B illustrate graphs showing the current-voltage characteristics of MOSFETs having different gate oxide thicknesses.

Fig. 2 illustrates a graph showing the on-resistance as a function of gate-to-source voltage of MOSFETs having different gate oxide thicknesses.

Fig. 3A illustrates a graph showing the threshold voltage as a function of gate oxide thickness for MOSFETs having various levels of body doping.

Fig. 3B illustrates a graph showing the on-resistance as a function of gate oxide thickness for MOSFETs having various levels of gate overdrive (V_{GS} - Vₜ).

Fig. 4A illustrates a graph showing the drain current as a function of gate-to-source voltage for MOSFETs having various gate oxide thicknesses.

Fig. 4B illustrates a graph showing the on-resistance (normalized) as a function of gate overdrive (V_{GS} - Vₜ) for MOSFETs having various gate oxide thicknesses.

Fig. 5A illustrates a graph showing the maximum gate-to-source voltage sustainable as a function of gate oxide thickness.

Fig. 5B illustrates a graph showing the on-resistance as a function of gate-to-source voltage of MOSFETs having different gate oxide thicknesses, with each curve terminating a the maximum sustainable gate-to-source voltage.

Fig. 5C illustrates a graph showing on-resistance as afunction of the guaranteed maximum gate-to-source voltage for MOSFETs having various levels of gate-to-source voltage.

Fig. 6 illustrates a graph showing the combination of body doping and gate oxide thickness required to assure a threshold voltage of 0.9 V and the gate oxide thickness at which 12 V and 30 V rated devices having a threshold voltage of 0.9 V break down.

Fig. 7A illustrates a cross-sectional view of a conventional trench-gated MOSFET.

Fig. 7B illustrates a cross-sectional view of a conventional vertical planar DMOSFET.

Fig. 7C illustrates a cross-sectional view of a conventional laterally lightly doped drain (LDD) MOSFET.

Fig. 7D illustrates a cross-sectional view of a conventional lateral DMOSFET.

Fig. 8 illustrates a schematic circuit diagram of an N-channel MOSFET containing a voltage-clamped gate in accordance with this invention.

Fig. 9A illustrates a current-voltage graph showing the forward and reverse breakdown voltages of the individual diodes in the voltage clamp.

Fig. 9B illustrates a current-voltage graph showing the breakdown voltage of each voltage clamp.

Fig. 9C illustrates a graph of the voltage between the source and gate internal to the MOSFET as a function of the voltage between the source and gate pads of the MOSFET.

Fig. 10A illustrates a graph of the current between the source and gate pads as a function of the voltage between the source and gate pads of the MOSFET, with the normal operating range of a lithium ion battery shown.

Fig. 10B illustrates a graph on a logarithmic scale showing the current through the voltage clamp as a function of the voltage between the source and gate pads, as well as the current between the source and gate pads if no voltage clamp is present.

Fig. 11A illustrates a schematic circuit diagram showing a battery switch containing two gate voltage clamped MOSFETs in accordance with this invention.

Fig. 11B illustrates graphs showing the battery charger voltage, the voltage across the voltage clamp and the current through the voltage clamp in the switch of Fig. 11A.

Fig. 12A illustrates a composite cross-sectional view of a trench-gated MOSFET in accordance with the invention containing two gate voltage clamps formed in polysilicon layers.

Fig. 12B illustrates a plan view of the MOSFET shown in Fig. 12A.

Fig. 12C illustrates a cross-sectional view how the gate is contacted in the MOSFET of Figs. 12A and 12B.

Fig. 13 illustrates a schematic circuit diagram of a MOSFET in accordance with this invention in which each of the voltage clamps contains a diode pair, with the diodes in the low-voltage clamp having different breakdown voltages from the diodes in the high-voltage clamp.

Fig. 14A illustrates a graph showing gate current as a function of gate voltage in a voltage clamp containing three pairs of back-to-back diodes.

Figs. 14B and 14C illustrate cross-sectional and plan views of the voltage clamp represented in Fig. 14A.

Fig. 14D illustrates a circuit diagram of the voltage clamp represented in Fig. 14A.

Fig. 15A illustrates a graph showing gate current as a function of gate voltage in a voltage clamp containing two pairs of diodes.

Figs. 15B and 15C illustrate cross-sectional and plan views of the voltage clamp represented in Fig. 15A.

Fig. 15D illustrates a circuit diagram of the voltage clamp represented in Fig. 15A.

Fig. 16A illustrates a graph showing gate current as a function of gate voltage in a voltage clamp containing three diodes directed in one direction and a single diode directed in the other direction.

Figs. 16B and 16C illustrate cross-sectional and plan views of the voltage clamp represented in Fig. 16A.

Fig. 16D illustrates a circuit diagram of the voltage clamp represented in Fig. 16A.

Fig. 17A illustrates a graph showing gate current as a function of gate voltage in a voltage clamp containing three diodes directed in the same direction.

Figs. 17B and 17C illustrate cross-sectional and plan views of the voltage clamp represented in Fig. 17A.

Fig. 17D illustrates a circuit diagram of the voltage clamp represented in Fig. 17A.

Fig. 18A illustrates a graph showing gate current as a function of gate voltage in a voltage clamp containing a parallel network of three diodes directed in the one direction and three diodes directed in the other direction.

Figs. 18B and 18C illustrate cross-sectional and plan views of the voltage clamp represented in Fig. 18A.

Fig. 18D illustrates a circuit diagram of the voltage clamp represented in Fig. 18A.

Fig. 19 illustrates a circuit diagram showing a MOSFET containing a voltage clamp of the kind shown in Figs. 18A-18D.

Fig. 20A illustrates a circuit diagram of a P-channel MOSFET containing a voltage-clamped gate in accordance with this invention.

Fig. 20B illustrates a circuit diagram of a gate voltage clamped MOSFET in accordance with this invention used in a level shifter.

Fig. 21 illustrates a cross-sectional view of a trench-gated MOSFET in accordance with this invention having a voltage clamp comprising a single diode formed in a deep P+ diffusion used to reduce the strength of the electric field near the corners of the gate trench.

Fig. 22 illustrates a cross-sectional view of the MOSFET of Fig. 21 in which the voltage clamp comprises a pair of back-to-back diodes.

Figs. 23A-23G illustrate cross-sectional views showing the steps of a process of fabricating a MOSFET in accordance with this invention.

### DESCRIPTION OF THE INVENTION

Figs. 7A-7D illustrate several forms of MOSFET to which the principles of this invention may be applied. Each is a cross-sectional view of a single MOSFET cell. It will be understood that the cell is replicated numerous times in an actual power MOSFET.

Fig. 7A shows a trench-gated MOSFET 700 formed in an N-epitaxial (epi) layer 702 grown on an N+ substrate 704, which function as the drain of the device. MOSFET 700 includes a trenched gate 706, a gate oxide layer 707, an N-type source region 708, a P-body 710 and a central deep P+ diffusion 712, which protects the gate oxide layer 707 against damage from high electric fields as taught in U.S. Patent No. 5,410,170 to Bulucea et al. A metal layer 714 forms a source-body contact at the surface of the silicon and a drain contact (not shown) is located at the opposite surface of the N+ substrate 708.

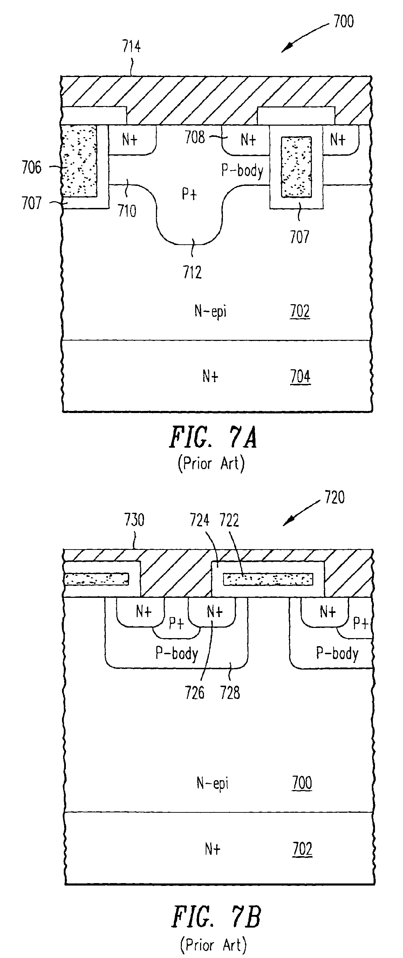

Fig. 7B shows a vertical planar double-diffused channel MOSFET (DMOS) 720 having a gate 722 formed over the surface of the silicon, a gate oxide layer 724, an N+ source region 726 and a P-body 728. A source-body contact is made by a metal layer 730.

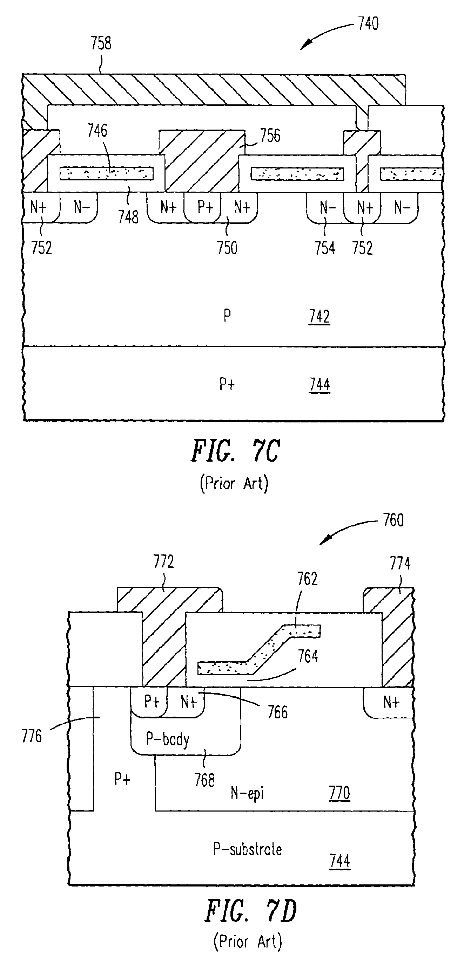

Fig. 7C shows a lateral lightly-doped drain (LLD) MOSFET 740 formed in a P-epi layer 742 over a P+ substrate 744. MOSFET 740 includes a gate 746, a gate oxide layer 748, an N+ source region 750 and an N+ drain region 752. A lightly doped N- region 754 reduces the electric field near the drain region 752. Metal layer 756 contacts the N+ source 750 and the P-body 742 and metal layer 758 contacts the drain region 752. The metall layers are arranged in a pattern to connect all of the device cells or stripes in parallel: drain to drain, source to source, and gate to gate.

Fig. 7D shows a drain-enclosed lateral DMOS 760 formed in an N-epi layer 770 over P substrate 744. DMOS 760 includes a gate 762, a gate oxide layer 764, an N+ source region 766 and a P-body 768. The drain is formed by N-epi layer 770 and is enclosed by a P+ sinker 776 which extends downward through the epi layer to the P substrate 744 and provides isolation for the drain. A metal layer 772 forms a source-body contact, and the drain 770 is contacted by metal layer 774.

Figs. 7A-7D are not intended to be limiting. It will be understood from the following discussion that the principles of this invention are applicable to numerous embodiments in addition to those illustrated in Figs. 7A-7D, for example, the device of Fig. 7B or 7D wherein a thicker field oxide is located under the portion of the polysilicon gate not covering the double-diffused channel.

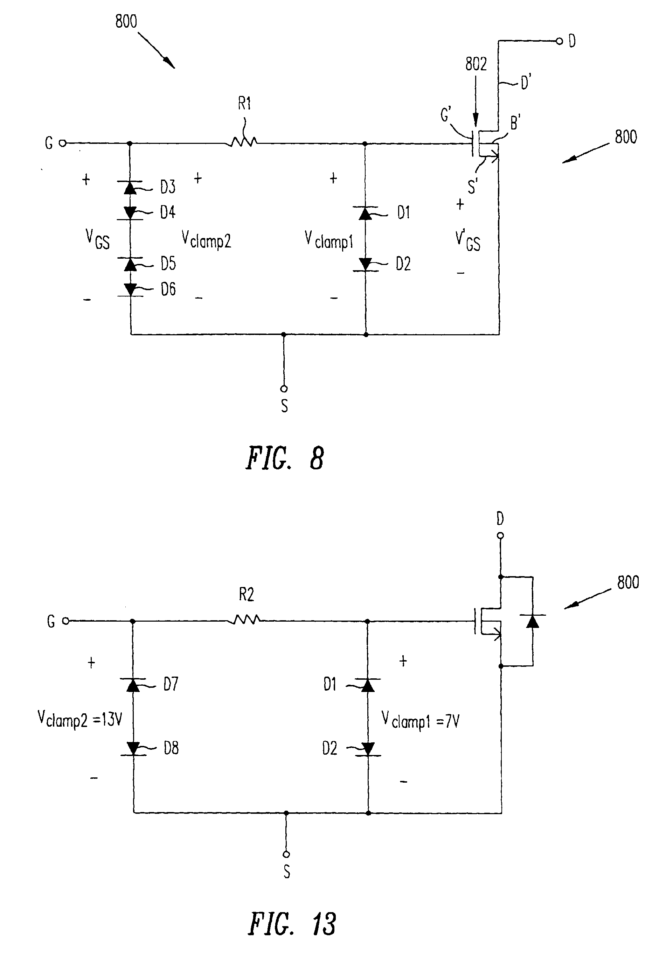

Fig. 8 illustrates a schematic circuit diagram of a MOSFET 800 in accordance with this invention. Included are a source terminal S, a drain terminal D and a gate terminal G. These terminals represent pads or other means of making contact externally to the device, and they are distinguishable from the actual components (source S', gate G', drain D') within the MOSFET. Thus the voltage between gate terminal S and source terminal S is represented as V_{GS} whereas the voltage between the gate G' and source S' within the MOSFET is represented as V_{GS}'. As indicated, the source S' and body B' of MOSFET 800 are shorted together, although this would not necessarily be the case in all embodiments. MOSFET 800 is shown as an N-channel MOSFET, but the principles of this invention are equally applicable to P-channel MOSFETs.

Connected in series between source S' and gate G' are diodes D1 and D2, which function as a voltage clamp V_{clamp1}. As indicated diodes D1 and D2 are connected "back-to-back" (i.e., anode-to-anode), and in normal operating conditions diodes D1 and D2 provide an open circuit between source S' and gate G', except for some junction leakage current associated with the reverse-biased diode. A second group of diodes D3, D4, D5 and D6 are connected in pairs back-to-back between source terminal S and gate terminal G, and together this group of diodes forms a second voltage clamp V_{clamp2}. The back-to-back configuration, while shown in a common anode version, may also be implemented in a common cathode version. Moreover, the stack of serial connected diodes D3 through D6 can be increased to larger numbers, e.g., by including additional pairs of diodes D7 and D8, D9 and D10, etc, until the desired breakdown voltage at the terminals S and G is met. A current limiting resistor R1 is connected between gate terminal G and gate G' and between the cathodes of diodes D1 and D3.

Because diodes D1-D6 are connected back-to-back in pairs, in normal operating conditions they provide an open circuit between source and gate terminals S and G and between the source S' and gate G' of MOSFET 800. In these conditions V_{GS} = V_{GS}' However, diodes D1-D6 are sized such that they break down at voltages which provide protection to the gate oxide layer 802 within MOSFET 800. For example, if V_{GS} = V_{GS}' becomes too high in the positive direction diode D1 will break down and clamp V_{GS}' at an acceptable level equal to the sum of the breakdown voltage of diode D1 and the forward voltage drop across diode D2 (the latter being typically about 0.7 V). A current then flows from gate terminal G to source terminal S, and this current is limited by the resistor R1. Resistor R1 can be a linear resistor, a nonlinear resistor, or a current-saturating resistor (e.g., a MOSFET or a JFET), but in any case it limits the size of the current flowing through diodes D1 and D2 to a tolerable level when voltage clamp V_{clamp1} is conducting. If diodes D1 and D2 are very large and have a low impedance, the value of resistor R1 could be very low and could in fact approach zero. In such a case, the current flowing through diodes D1 and d2 would be limited by the impedance of the gate drive circuitry that is used to provide a bias to gate G'.

Conversely, if V_{GS} = V_{GS}' becomes too high in the negative direction diode D2 will break down and clamp V_{GS}' at an acceptable level equal to the sum of the breakdown voltage of diode D2 and the forward voltage drop across diode D1. If there is no risk of negative voltage swings, diode D2 could be omitted. Diode D2 is frequently included to make the device a general purpose MOSFET.

The second voltage clamp V_{clamp2}, which is optional, provides a second level of protection to MOSFET 800. Clamp V_{clamp2} sets a maximum limit on the voltage between source terminal S and gate terminal G. If diodes D1-D6 are identical, for example, clamp V_{clamp2} will break down at a voltage that is twice as high as the breakdown voltage of clamp V_{clamp1}. Clamp V_{clamp2} also sets a limit on the voltage across resistor R1. This allows the maximum current density through diodes D1 and D2 to be controlled and predicted. Although clamp V_{clamp2} may be destroyed if the voltage gets high enough, at least MOSFET 800 will be protected. If the second voltage clamp is not included, the voltage across the gate oxide could still get so high that it would be ruptured, primarily because the maximum terminal voltage could be increased until the voltage drop across voltage clamp V_{clamp1} begins to rise as a result of heating and its own series resistance. In normal operating conditions the series resistance of voltage clamp V_{clamp1} should be small in comparison with the value of resistance R1.

The voltage clamps protect against electrostatic discharge (ESD) pulses as well as much more enduring voltage swings. Although ESD pulses present very high voltages, they are very short-lived. If ESD pulses are the only concern, diodes D1 and D2 can be made relatively small. Other types of abnormalities, such as those created by a voltage charger, present much longer lived voltages, and diodes D1-D6 must be made more robust to survive these situations, ideally in an indefinitely long steady-state condition.

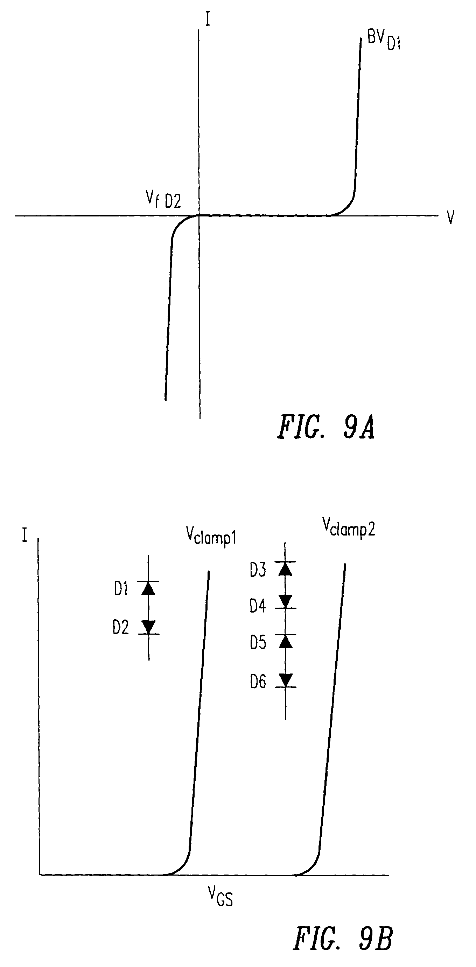

Fig. 9A is a graph showing the forward and reverse current-voltage characteristics of diodes D1 and D2. The reverse bias breakdown (BV_{D1}) could be on the order of 7 V, for example, while the forward drop (V_{f}) is normally 0.6 to 0.7 V. As shown in Fig. 9B, these voltages would be summed to arrive at the current-voltage characteristic of the back-to-back pair of diodes D1 and D2. As also shown in Fig. 9B, the current-voltage characteristic of clamp V_{clamp2} is the sum of the reverse breakdown voltages of the diodes D3 and D5 and forward drops across diodes D2 and D6.

Fig. 9C shows V_{GS}' as a function of V_{GS}. V_{GS}' equals V_{GS} until the voltage at which clamp V_{clamp1} breaks down, after which it remains at that breakdown voltage. At some point the second clamp V_{clamp2} breaks down. Provided that the current flowing through voltage clamp V_{clamp2} is not increased to excessive levels, the voltage across voltage clamp V_{clamp2} will remain constant, as will the current flowing in the resistor R1.

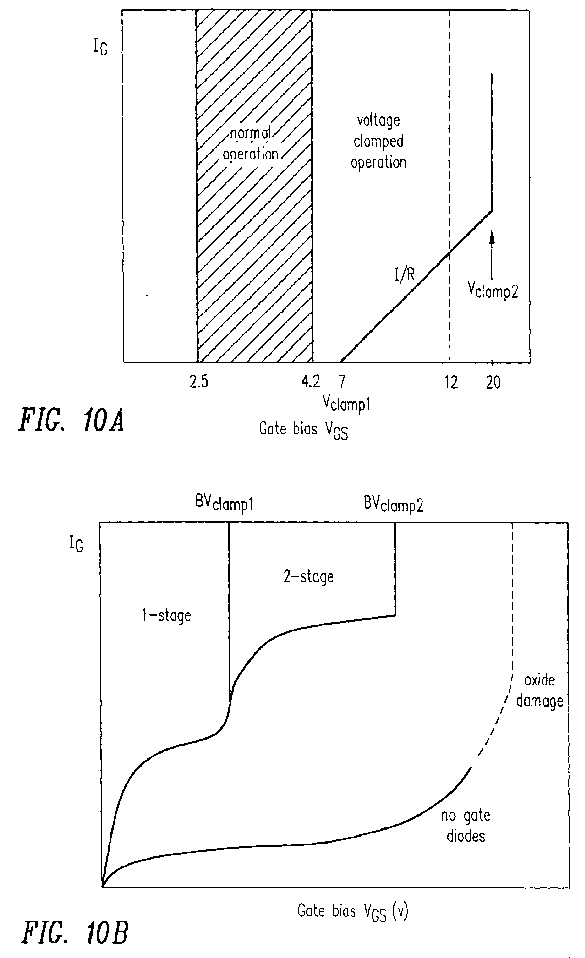

Fig. 10A is a graph showing the current through the clamping network as a function of V_{GS}. The normal operating range for a lithium ion battery (2.5-4.2 V) is indicated. The breakdown voltage of V_{clamp1} is set at 7 V, after which the current rises at a slope of 1 divided by the value of R1 until V_{clamp2} breaks down at 20 V. Thus the normal operating range is below the breakdown voltage of V_{clamp1}, and the breakdown voltage of V_{clamp1} is set at a level at or slightly below the maximum safe operating voltage of the gate oxide (4 MV/cm for thick oxides and perhaps 5-6 MV/cm for thin oxides). Thus the circuit shown in Fig. 10A could be designed for an 7 or 8 V gate oxide. V_{GS} up to 12 V could easily be handled (and even up to 20 V), and this would constitute the safe operating range of the device, beyond which the device would be in a fault condition.

Fig. 10B shows on a logarithmic scale the gate current I_{G} (i.e., the current between the gate terminal G and the source terminal S) as a function of V_{GS}. In stage 1 there is a leakage current through V_{clamp1} which is limited by resistor R1. If V_{GS} continues to rise, eventually V_{clamp1} breaks down, with I_{G} then rising at a higher rate of increase. The rate of increase is fairly steady in stage 2, until V_{clamp2} breaks down, at which point I_{G} shoots sharply upward. Too much current in voltage clamp V_{clamp2} may damage one of the diodes D3 through D6, but resistor R1 helps to protect diodes D1 and D2 under similar conditions. If voltage clamp V_{clamp2} is exposed to transients having only limited energy (or even current-limited DC conditions), then both voltage clamp V_{clamp1} and voltage clamp V_{clamp2} will survive indefinitely in situations where voltage clamp V_{clamp1}. is in breakdown provided that resistor R1 is large enough to prevent excessive currents from flowing through voltage clamp V_{clamp1}.

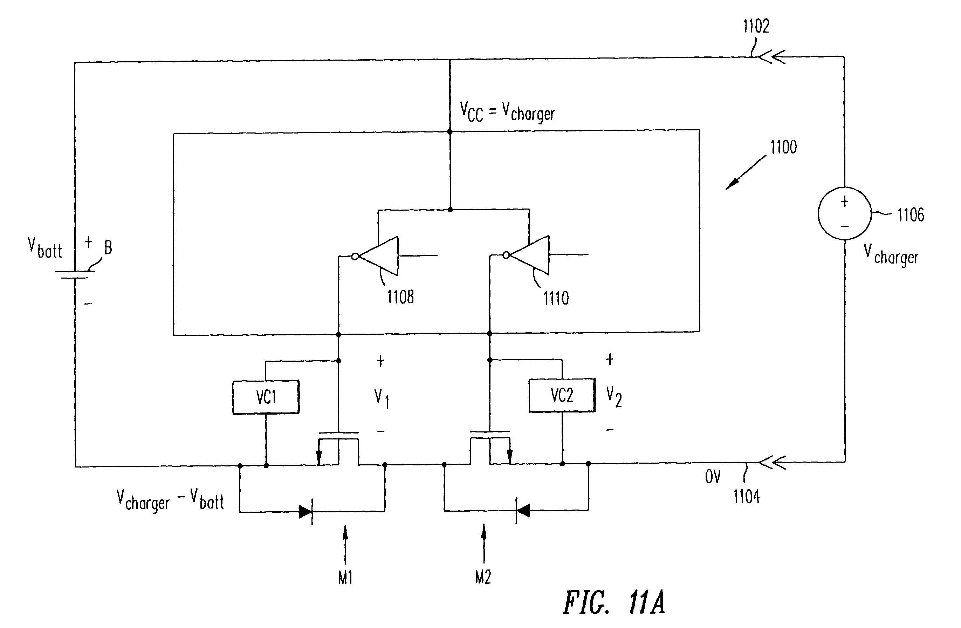

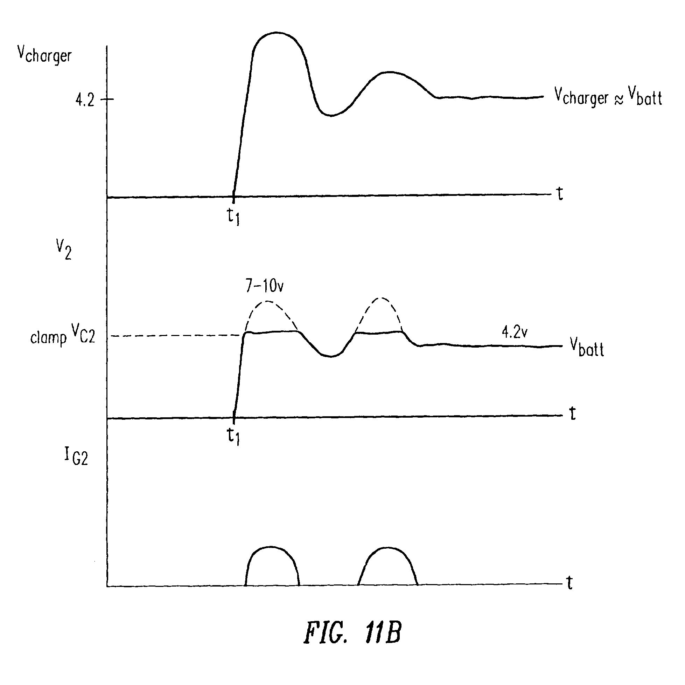

A circuit using MOSFETs according to this invention is shown in Fig. 11A. Switch 1100 containing common drain connected back-to-back MOSFETs M1 and M2 is used to control a battery B, which could be a lithium ion battery. Terminals 1102 and 1104 are connected to a power-driven device or (as shown) to a battery-charger 1106. A first voltage clamp V_{C1} is connected between the source and gate of MOSFET M1; a second voltage clamp V_{C2} is connected between the source and gate of MOSFET M2. The gates of MOSFETs M1 and M2 are controlled by gate buffers 1108 and 1110, respectively, which supply the gate drive voltage. With the battery charger 1106 connected, MOSFET M2 is turned on, which means that buffer 1110 delivers V_{CC} = V_{charger} to the gate of MOSFET M2. Since battery charger 1106 would typically deliver a voltage V_{charger} that is in excess of the maximum permissible voltage across the gate oxide of MOSFET M2, claim V_{C2} protects the gate oxide of MOSFET M2 against damage until V_{CC} = V_{charger} reaches a safe level.

Fig. 11B is a graph illustrating the behavior of the circuit of Fig. 11A when the battery charger 1106 is turned on at time t₁-for example, at the moment the charger is connected to the battery or when the charger is plugged into the AC wall receptacle. V_{charger} rings up to 7 to 10 V until it settles down to the charging level of about 4.2 V for a lithium ion battery. During this period clamp V_{C2} breaks down and limits the voltage across the gate oxide of MOSFET M2. As clamp V_{C2} breaks down, a current I_{G2} flows between the source and gate terminals of MOSFET M2. The power loss represented by this current is minor, and it comes from the battery charger 1106, so efficiecy loss is not a concern.

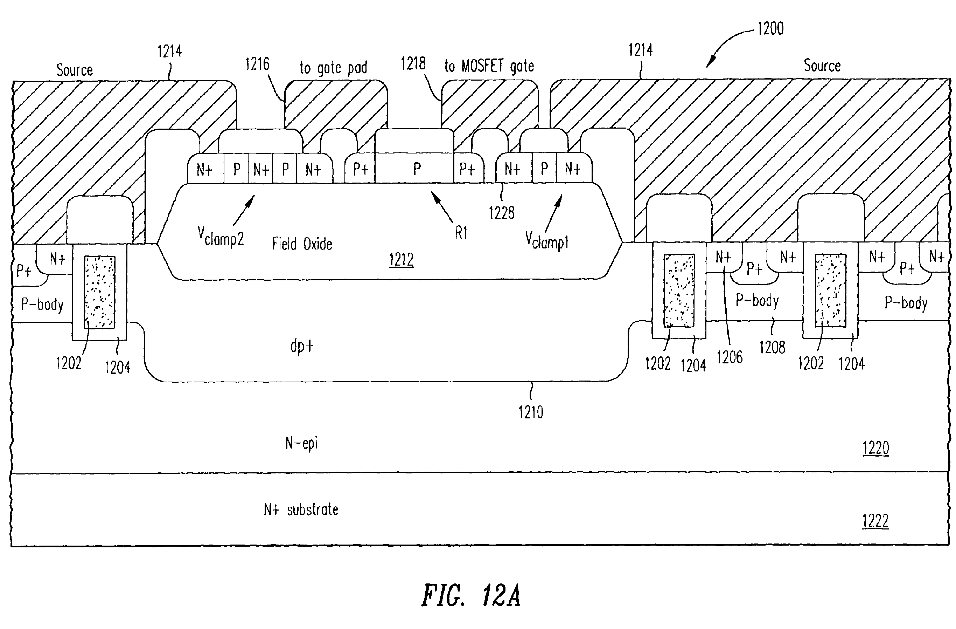

Fig. 12A shows a cross-sectional view of a MOSFET 1200 which includes a voltage clamp according to this invention. MOSFET 1200 is a trench-gated MOSFET each cell of which contains an N+ source region 1206 and a P-body 1208. N+ substrate 1222 and N-epi 1220 form the drain of MOSFET 1200. The trenched gates 1202 are separated from the silicon by gate oxide layer 1204. Protection for the gate oxide is provided by a deep P+ diffusion 1210 which underlies a field oxide region 1212. Source metal layer 1214 makes source-body contacts and also contacts deep P+ diffusion 1210. The drain is contacted on the bottom of the substrate 1222.

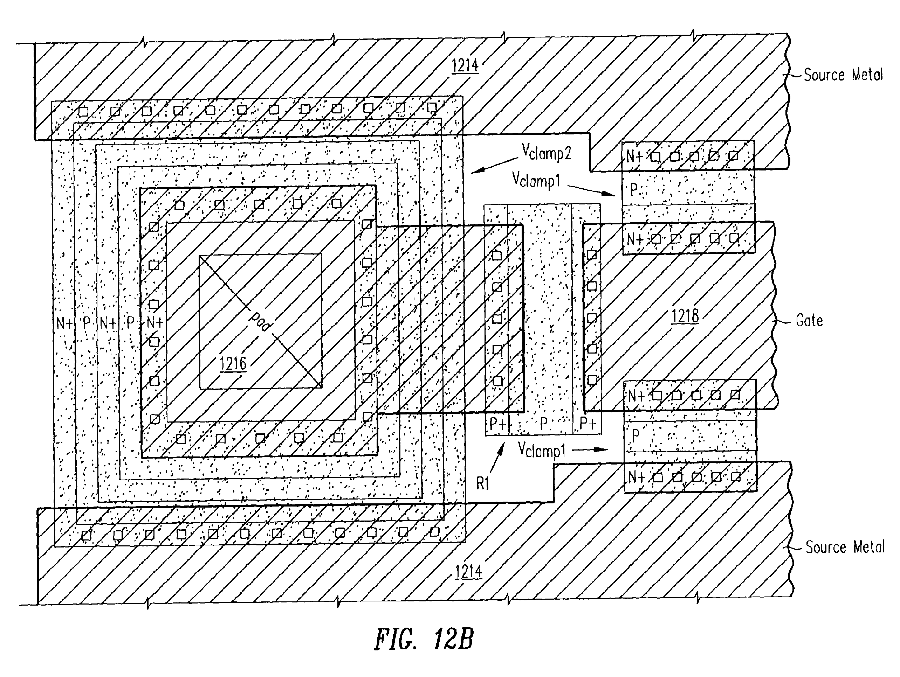

Voltage clamps V_{clamp1} and V_{clamp2} and resistor R1 are formed in polysilicon in the top surface of field oxide region 1212. Fig. 12A is a composite cross-sectional view of the MOSFET which is shown in plan view in Fig. 12B. Clamp V_{clamp1} comprises a linear arrangement of two N+ strips separated by a P strip, and clamp V_{clamp2} comprises a annular arrangement of five alternating N+ and P strips. Resistor R1 comprises a P-type region. A metal layer 1218 ties clamp V_{clamp1} to resistor R1, and a metal layer 1216 ties V_{clamp2} to resistor R1. The solid squares in Fig. 12B represent contacts between the overlying metal layers and the silicon beneath. Note that for clarity the MOSFET structure is not shown in Fig. 12B. In reality, the MOSFET cells are located under the source metal layer 1214.

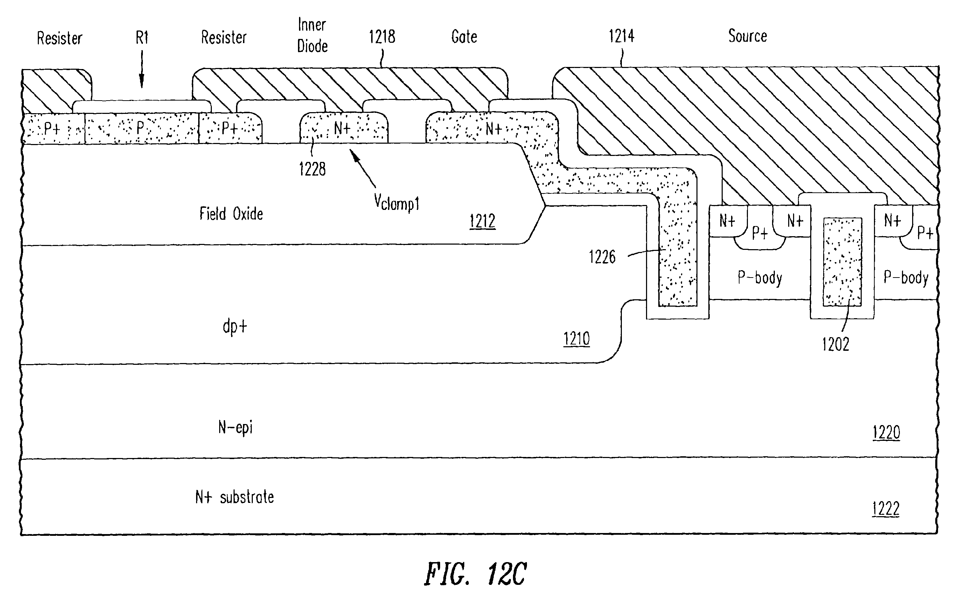

Fig. 12C is a cross-sectional view showing how the gate is contacted by allowing the polysilicon 1226 from the trench to come up to the top of the field oxide region, where it is contacted by the metal layer 1218. Metal layer 1218 also contacts a cathode 1228 of one of the diodes in clamp V_{clamp1} (see also Fig. 12A) and the resistor R1. The other components of clamp V_{clamp1} and the entirety of clamp V_{clamp2} are outside the plane of Fig. 12C and are not shown.

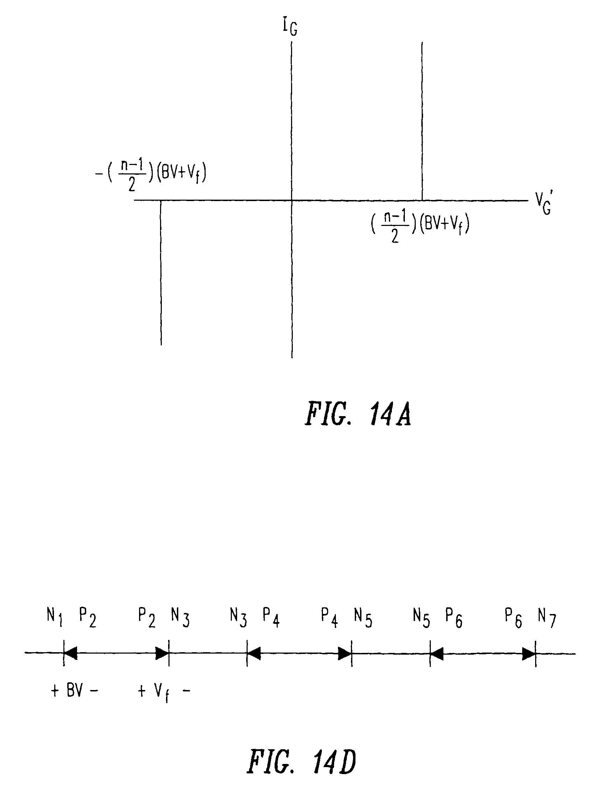

Fig. 13 illustrates a circuit diagram of an alternative embodiment in which clamp V_{clamp2} contains diodes D7 and D8 that have a lighter doping than diodes D1 and D2 and therefore have a higher breakdown voltage (e.g., 13 V).

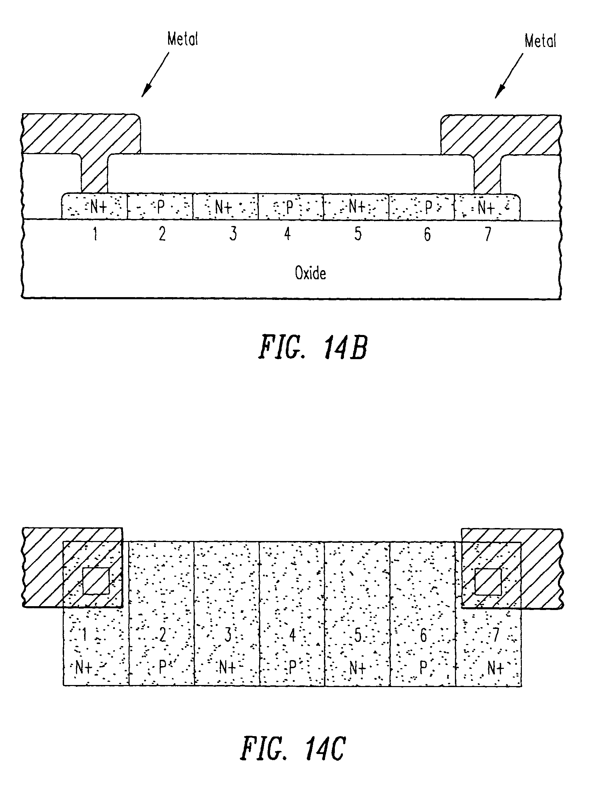

Figs. 14A-14D, 15A-15D, 16A-16D, 17A-17D and 18A-18D show alternate arrangements of diode clamps that can be used in embodiments of this invention. In each of these drawing groups, "A" is a graph showing the forward and reverse breakdown voltages of the clamp as a function of the number of N and P doped regions and the forward (V_{f}) and reverse (BV) voltage drops across the PN junctions during conduction. "B" and "C" are cross-sectional and plan views, respectively, of the clamps formed in polysilicon over an oxide layer, and "D" is a schematic circuit diagram of the constituent diodes.

The clamp shown in Figs. 14A-14D contains symmetrical serially arranged back-to-back diode pairs with a contact to only N+ regions. Such a structure requires contacts only to the outer N+ regions of the diode string. The number of regions, n, being an odd number (3, 5, 7, etc.) provides incremental voltage steps of (BV + V_{f}). If n is less than 3, the structure no longer represents a back-to-back diode pair, and the equation shown in Fig. 14A is not valid. Note that when N = 3, V_{clamp} = BV + V_{f}, which is the minimal voltage for a bidirectional clamp, roughly 6 V. Thus structures containing forward-biased diodes are preferably used to protect gate oxides thinner than about 120 Å (since 120 Å x 5MV/cm = 6 V).

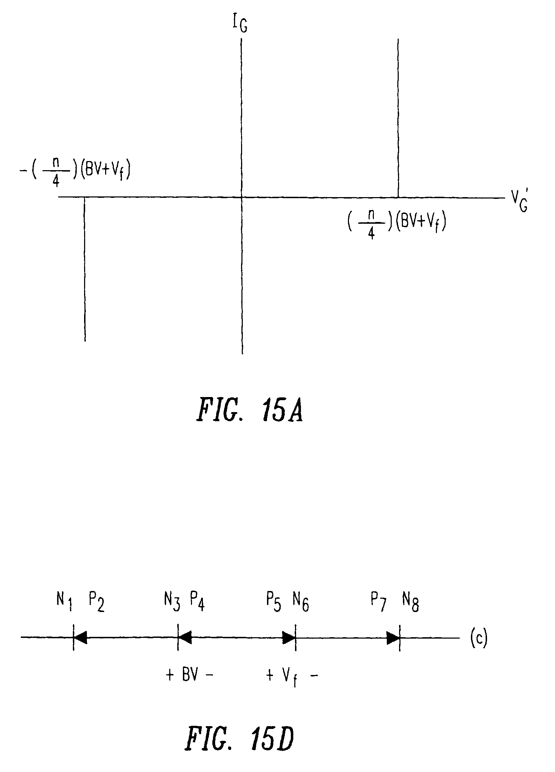

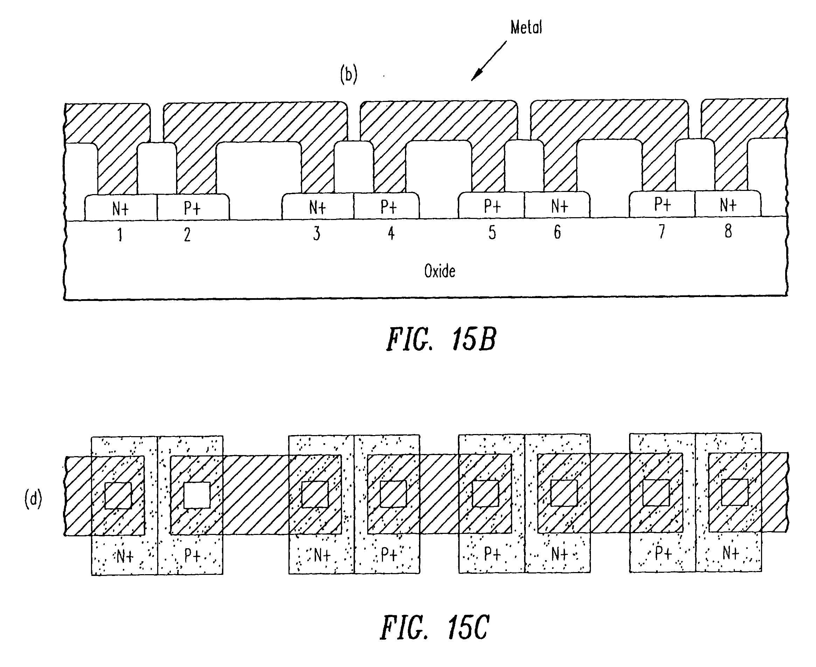

The clamp shown in Figs. 15A-15D contains serially arranged diodes pairs with contacts to N+ and P+ regions, again configured with an equal number of diodes pointing in each direction. The minimum voltage is that represented by a single pair of back-to-back diodes (BV + V_{f}), as in an arrangement of the kind shown in Figs. 14A-14D.

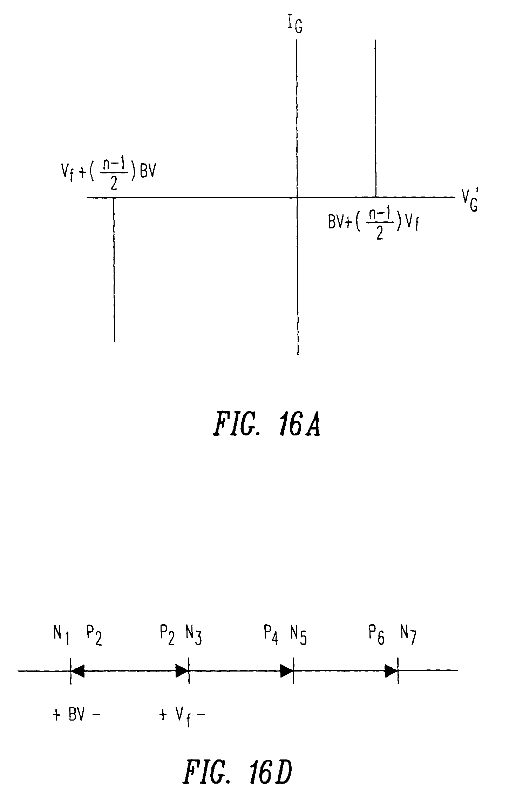

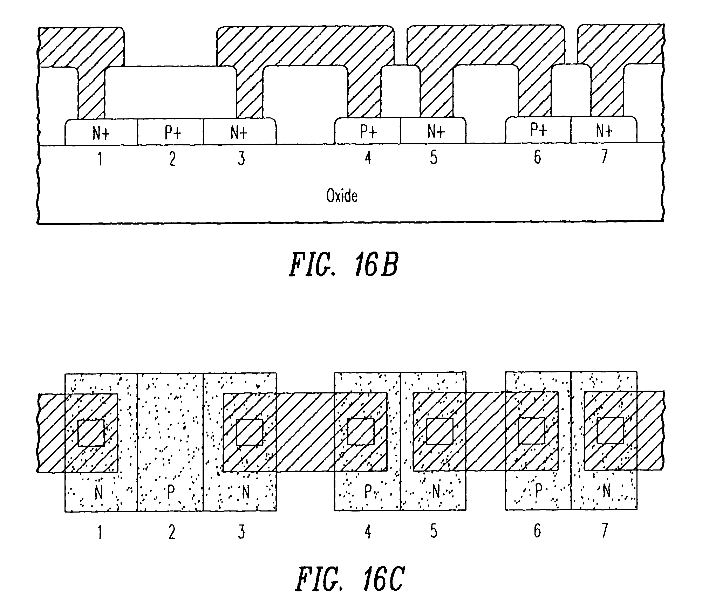

The clamp shown in Figs. 16A-16D contains asymmetrical diodes with contacts to N+ and P+ regions. In one direction the clamping voltage is one breakdown voltage plus several forward-biased diode drops. In the other direction, the clamping voltage is a single forward-biased diode drops plus several reverse-biased avalanche breakdown voltages.

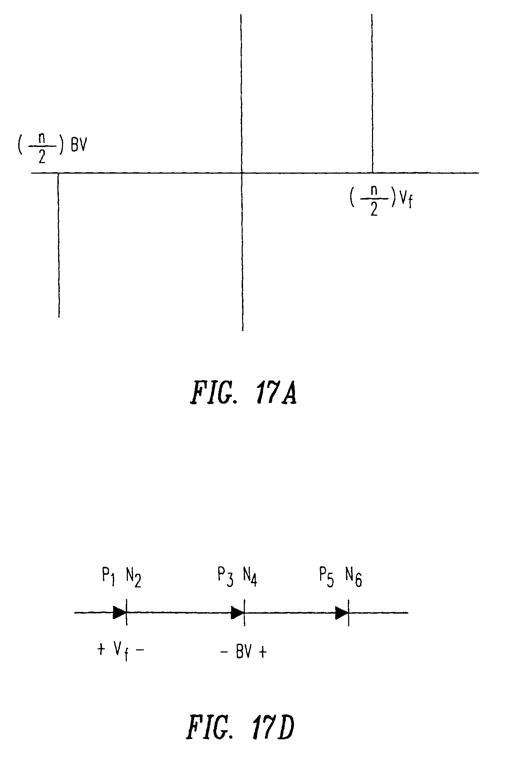

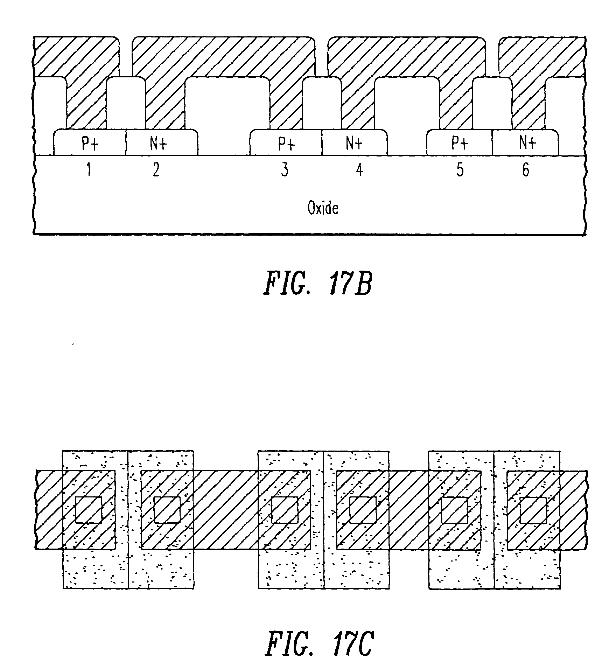

The clamp shown in Figs. 17A-17D contains highly asymmetrical diodes with contacts to N+ and P+ regions (minimum voltage = BV in one direction and V_{f} in the other direction). The clamping voltage in one direction is the number of diodes times the their breakdown voltages, and the clamping voltage in the other direction is the number of diodes times a forward-biased diode voltage drop. If this network is used to protect an oxide by choosing the breakdown voltage near the 4-5 MV/cm industry standard for the voltage drop across the gate oxide layer, operation in the other direction will be limited to one or a few forward diode drops before the onset of conduction. If the forward-biased direction is matched to the oxide protection voltage, then the diode network will not provide protection in the opposite direction. Such an assymetrical network may still be useful in two-stage clamp circuits, however.

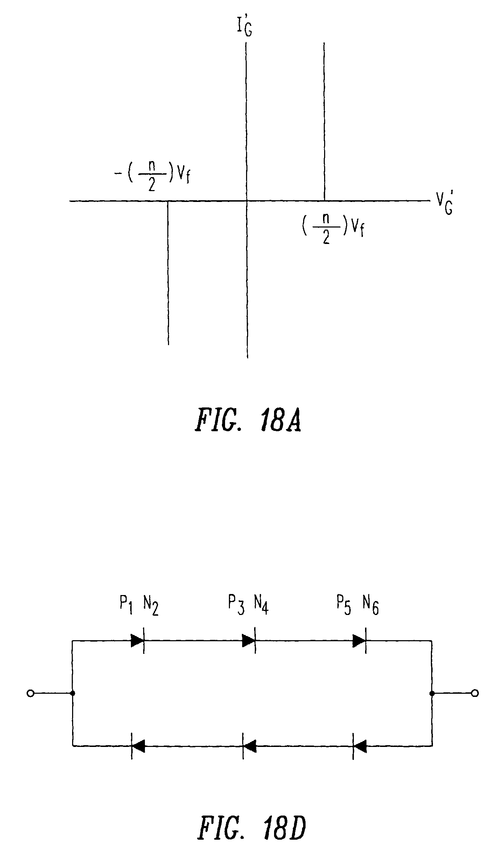

The clamp shown in Figs. 18A-18D contains a network of diodes in one direction connected in parallel with diodes in the other direction requiring both N+ and P+ contacts. Figs. 18A-18D illustrate a solution to the assymetrical protection limit of Figs. 17A-17D by using two antiparallel networks. Since diodes become forward-biased in either direction, true bidirectional protection can be achieved.

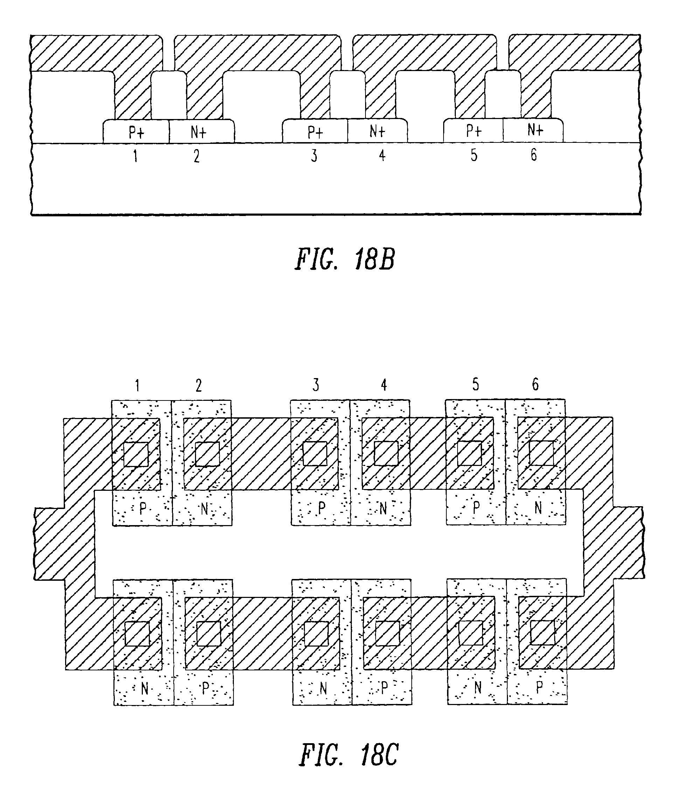

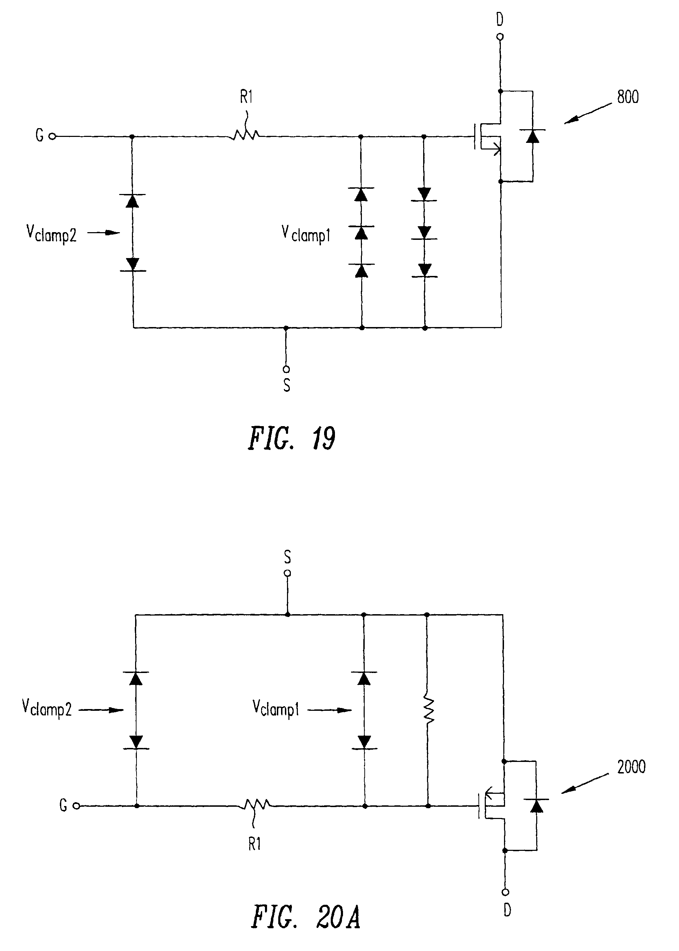

Fig. 19 shows a circuit containing a clamp V_{clamp1} similar to the parallel network shown in Fig. 18 and a clamp V_{clamp2} containing a single pair of back-to-back diodes. In this circuit, the outer voltage clamp V_{clamp2} is implemented using the circuit of Figs. 14A-14D, 15A-15A-15D or 16A-16D and the inner voltage clamp V_{clamp1} of Figs. 17A-17D or 18A-18D. In a preferred embodiment voltage clamp V_{clamp2} would employ the circuit of Figs. 14A-14D because it uses less chip area (since the contacts and metal interconnects are avoided within the diode stack). In the preferred embodiment voltage clamp V_{clamp1} is implemented using the circuit of Figs. 18A-18D because it is symetrical in its blocking and protects the gate oxides having a thickness of less than 120 Å (i.e., gates oxide capable of operating at a maximum V_{GS} of 6 V).

Fig. 20A shows a circuit diagram of a P-channel MOSFET 2000 with clamps V_{clamp1} and V_{clamp2} connected between its source and gate; and Fig. 20B shows MOSFET 2000 connected in a level shifting arrangement with an N-channel MOSFET 2004. These embodiments illustrate that the diode protection network of voltage clamps V_{clamp1} and V_{clamp2} and resistor R1 can be used to protect a P-channel MOSFET as well as an N-channel MOSFET. Moreover, the optional shunt resistor R2 can be connected between the source S' and gate G' of MOSFET 2000 to hold MOSFET 2000 off in the absence of a gate input signal, or if the resistance of the gate drive circuitry is too high to maintain an off condition externally, or if the value of resistor R1 is too large to guarantee that an externally applied short between terminals S and G will lead to source S' and gate G' being maintained at the same potential during transients experienced at the drain terminal D.

In Fig. 20B,the protective circuitry of Fig. 20A is used to implement a circuit function, not just to survive a fault condition. P-channel MOSFET is used to switch a load 2002. Given an input signal V_{logic}, which is not necessarily the same as, and is possibly less than, the value of V_{CC}, the input signal V_{logic} cannot drive the P-channel MOSFET 2000 directly. By providing level shifting MOSFET 2004, which has a BV_{DSS} breakdown rating in excess of the maximum expected V_{CC}, then the gate of the P-channel MOSFET 2000 becomes controlled by a combination of the clamping network and the level-shifting MOSFET 2004. For example, when V_{logic} is at zero volts, the N-channel MOSFET 2004 is turned off and the external gate pin 2006 is floating. In such a case, resistor R3 holds the gate G' and source S' at the same voltage, and MOSFET 2000 remains off. When MOSFET 2004 receives an input signal V_{logic} that is above its threshold voltage, MOSFET 2004 turns on and attempts to pull the gate G' of MOSFET 2000 to ground. Without the protection network, any value of V_{CC} greater than the maximum gate voltage rating of MOSFET 2000 will damage that device. With the protection network, and with voltage clamp V_{clamp1} being designed to protect the gate oxide of MOSFET 2000, voltage clamp V_{clamp1} will break down if V_{CC} becomes too high, and the resistor R1 will limit the current through voltage clamp V_{clamp1}. Voltage clamp V_{clamp2} ideally should not break down, since it is not current-limited, unless the saturation current of MOSFET 2004 is very small. In other words, the network accomplishes the level shifting function with only a single external component.

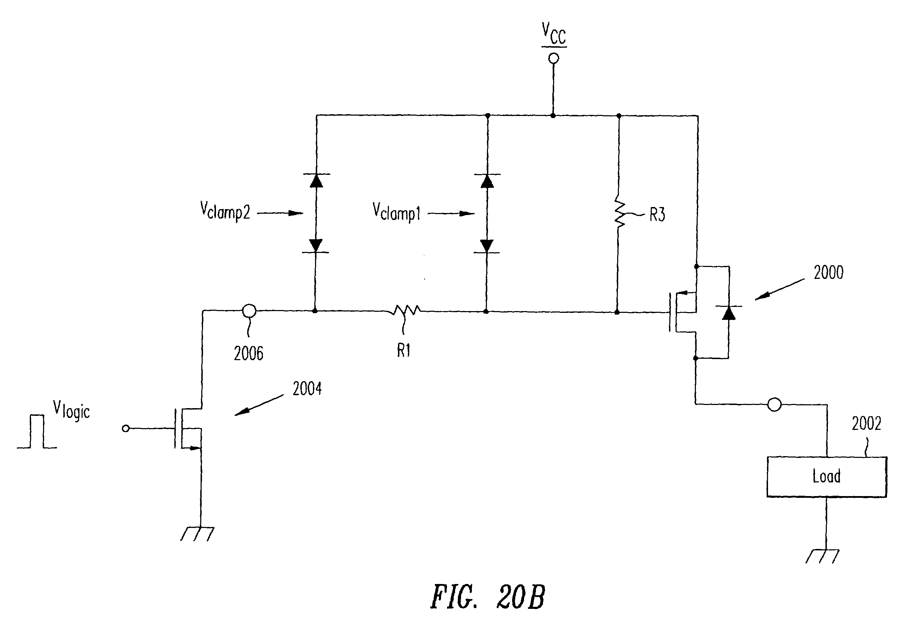

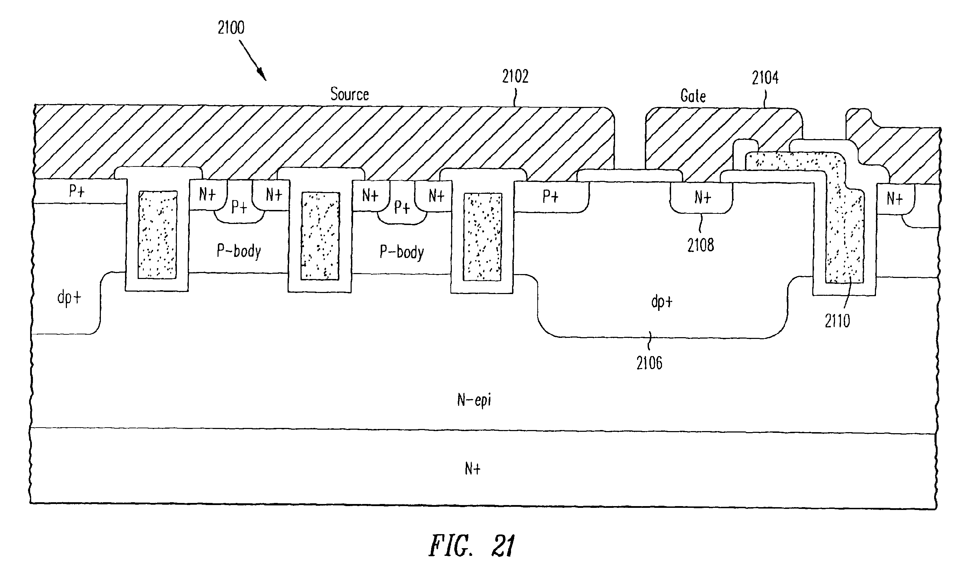

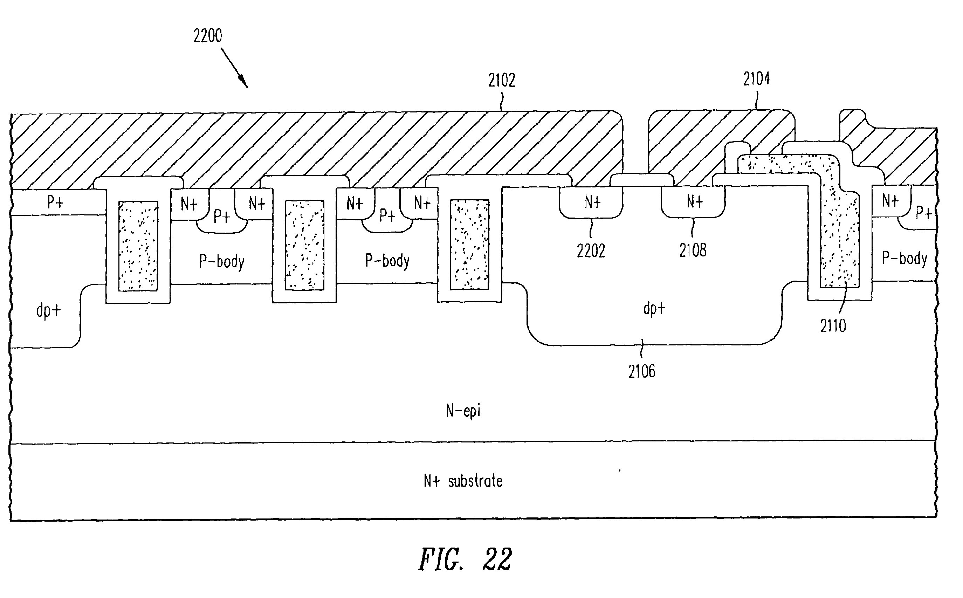

Fig. 21 shows a cross-sectional view of a trench-gated N-channel MOSFET 2100 wherein a single diode is used to clamp the gate to the source. The clamp is formed at the junction between an N+ region 2108 and a deep P+ diffusion 2106. A source metal layer 2102 connects the deep P+ diffusion 2106 to the source regions of the MOSFET, and a gate metal layer 2104 connects the N+ region 2108 to a gate section 2110. The MOSFET 2200 shown in Fig. 22 is identical to MOSFET 2100 except that the source metal 2102 contacts an N+ region 2202 thereby creating back-to-back diodes between the source and gate.

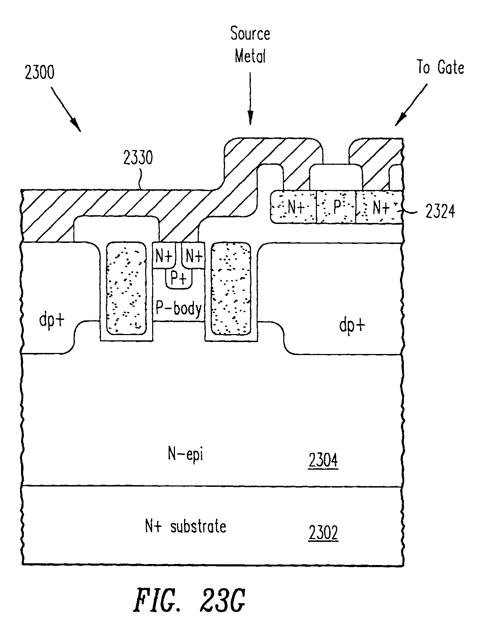

Figs. 23A-23G illustrate a process sequence for fabricating a MOSFET 2300 containing a gate clamp of the general kind found in MOSFET 1200 (Fig. 12A), wherein the gate clamp includes a series of N+ and P regions in a polysilicon layer on top of an oxide layer. An N-epi layer 2304 is grown in an N+ substrate 2302. The top surface and of N-epi layer 2304 is masked and deep P+ diffusions 2306 are implanted and diffused. A thick oxide layer is formed on the top surface of the N-epi layer 2304, yielding the structure shown in Fig. 23A.

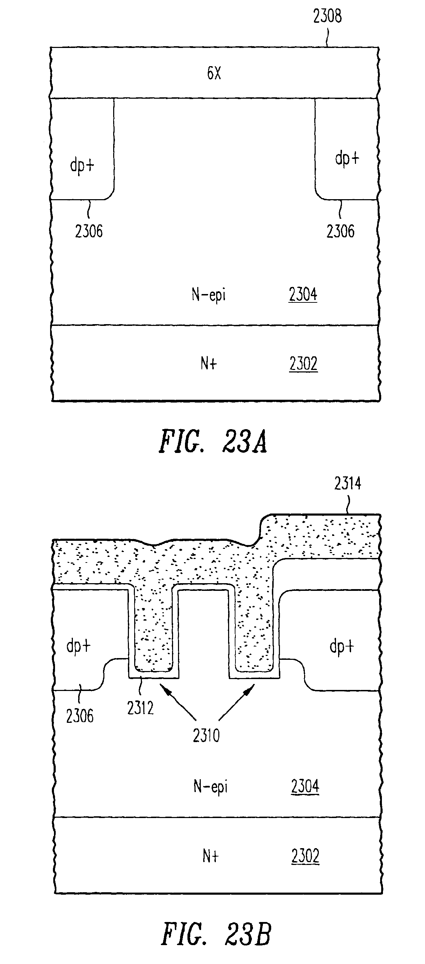

A portion of oxide layer 2308 is removed. Trenches 2310 are patterned and etched. A sacrificial oxide layer is grown and removed and a gate oxide layer 2312 is grown on the walls of the trenches 2310. A polysilicon layer 2314 is deposited, yielding the structure shown in Fig. 23B.

A gap 2316 is etched in polysilicon layer 2314. An implant blocking mask 2318 is formed over a portion of polysilicon layer 2314 and the remainder of polysilicon layer 2314 (including the portion in the gate trenches 2310) is subjected to a blanket implant of N-type dopant, yielding the structure shown in Fig. 23C.

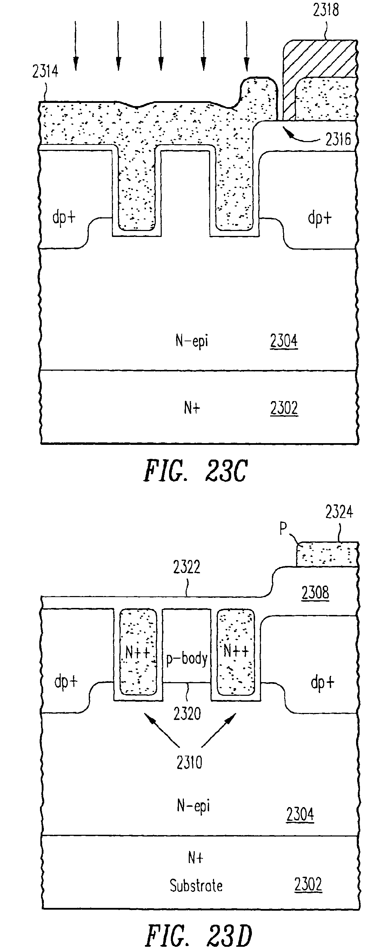

The portion of polysilicon layer 2314 in the area of the trenches 2310 is etched to planarize the surface. A thin oxide layer 2322 is grown, and P-body 2320 is implanted and diffused. The P-type dopant also is implanted in the polysilicon layer 2324 which remains on the top surface of the thick oxide layer 2308. This yields the structure shown in Fig. 23D.

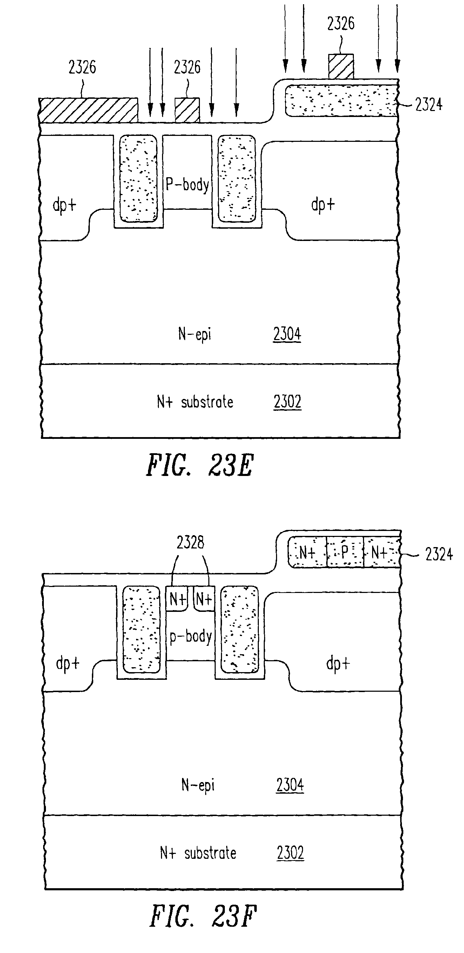

A thin oxide layer is formed on the top surface of the device. A mask 2326 is deposited to define the areas where in the N+ source regions and the N+ regions in the polysilicon layer 2324 are to be formed and N-type dopant is implanted, as shown in Fig. 23E, yielding a structure which contains N+ source regions 2328 and the N+ regions in polysilicon layer 2324 shown in Fig. 23F.

The device is masked for the metal contact, and a metal contact layer 2330 is deposited and pattern etched, yielding the structure shown in Fig. 23G. A portion of metal layer 2330 serves as the source metal contact and a second portion is connected to the gate (for example, in the manner shown in Fig. 21). The source metal and gate metal are connected through back-to-back diodes formed in polysilicon layer 2324. Optionally, a P-type implant may be performed after the contact mask has been formed, and the implanted dopant may be driven in by an anneal.

The embodiments described above are illustrative only and should not be interpreted as limiting the broad scope of this invention. Many additional embodiments in accordance with this invention will be apparent to those skilled in the art.

## Claims

1. A MOSFET comprising a source, a drain and a gate, said source being separated from said gate by an insulating layer, said MOSFET further comprising a voltage clamp connected between said source and said gate, said voltage clamp limiting the difference between a first voltage at said source and a second voltage at said gate to a predetermined clamping voltage so as to prevent damage to said insulating layer.

2. The MOSFET of Claim 1 wherein said source, said drain, said gate and said voltage clamp are formed in a single integrated circuit die.

3. The MOSFET of Claim 1 wherein said voltage clamp comprises at least one diode.

4. The MOSFET of Claim 3 wherein said diode comprises a junction between a region doped with P-type impurity and a region doped with N-type impurity.

5. The MOSFET of Claim 4 further comprising a gate terminal coupled to said gate and a source terminal coupled to said source.

6. The MOSFET of Claim 5 further comprising a second voltage clamp connected between said source terminal and said gate terminal, said second voltage clamp having a second clamping voltage the absolute value of which is greater than the absolute value of said predetermined clamping voltage.

7. The MOSFET of Claim 6 further comprising a resistor connected in a series path with said diode between said source terminal and said gate terminal.

8. The MOSFET of Claim 3 wherein said voltage clamp comprises first and second diodes connected in series anode-to-anode.

9. The MOSFET of Claim 3 wherein said voltage clamp comprises first and second diodes connected in series anode-to-cathode.

10. A MOSFET formed in a semiconductor die, said MOSFET comprising:
a source region doped with impurity of a first conductivity type;
a body region doped with impurity of a second conductivity type forming a first PN junction with said source region;
a drain region doped with impurity of said first conductivity type forming a second PN junction with said body region;
a gate separated from a channel portion of said body region by an insulating layer;
a first polysilicon layer comprising at least a first region of said first conductivity type and a second region of said second conductivity type, said first region forming a third PN junction with said second region;
a first conductive path connecting said first polysilicon layer and said source region; and
a second conductive path connecting said first polysilicon layer and said gate.

11. The MOSFET of Claim 10 wherein said gate is formed in a trench in said semiconductor die.

12. The MOSFET of Claim 10 wherein said first polysilicon layer is formed on a field oxide layer.

13. The MOSFET of Claim 10 comprising a second polysilicon layer, said second polysilicon layer comprising at least a third region of said first conductivity type and a fourth region of said second conductivity type, said third region forming a fourth PN junction with said third region.

14. The MOSFET of Claim 13 comprising a third polysilicon layer doped with impurity and a third conductive path connecting said second and third polysilicon layers.

15. The MOSFET of Claim 14 wherein said third conductive path connects said second and third polysilicon layers to a gate pad.

16. The MOSFET of Claim 15 wherein said first conductive path connects said third polysilicon layer to said source region.

17. The MOSFET of Claim 14 wherein said first, second and third conductive paths comprise first, second and third metal layers, respectively.

18. The MOSFET of Claim 10 wherein said insulating layer comprises silicon dioxide.
